# FASCICULE DE BREVET EUROPEEN

(11) **EP 1 886 545 B1**
(45) Date de publication et mention de la délivrance du brevet: **16.07.2008**
(21) Numéro de dépôt: 06764692.7
(22) Date de dépôt: 29.05.2006
(51) Int. Cl.: H05K 7/14

(54) **CALE EXPANSIBLE ET SYSTEME COMPRENANT UN MODULE, UN RECEPTACLE ET UNE TELLE CALE INTERCALEE ENTRE EUX**
ERWEITERBARER KEIL UND SYSTEM MIT EINEM MODUL, EINEM AUFNEHMER UND EINEM DAZWISCHEN ANGEORDNETEN SOLCHEN KEIL
EXPANDABLE WEDGE AND SYSTEM COMPRISING A MODULE, A RECEPTACLE AND SUCH A WEDGE INTERPOSED BETWEEN THEM

(30) Priorité: 31.05.2005 FR 0505489
(43) Date de publication de la demande: 13.02.2008
(73) Titulaire: SAGEM Défense Sécurité, 75015 Paris (FR)
(72) Inventeur: MERLET, Etienne, F-78180 Montigny le Bretonneux (FR); BESOLD, Jean-Eric, F-91400 Saclay (FR)
(74) Mandataire: Bérogin, Francis
(86) Numéro de dépôt international: PCT/FR2006/001215
(87) Numéro de publication internationale: WO 2006/129004

(56) Documents cités:
- EP-A- 0 780 932
- FR-A- 2 709 915
- FR-A- 2 778 056
- FR-A- 2 779 901
- US-A- 4 819 713
- US-A- 4 821 147
- US-A- 5 224 016

## Description

L'invention concerne une cale, ainsi qu'un système comprenant un module électronique, un réceptacle et une telle cale interposée entre eux pour assurer le serrage du module dans le réceptacle.

Bien que l'invention ne soit pas limitée à ce domaine, les problèmes auxquels ont été confrontés les inventeurs se sont posés dans l'avionique, où pour certaines applications, telles que les commandes de vol, l'électronique embarquée est rassemblée dans des modules blindés contenant une ou plusieurs cartes de circuits intégrés, ces modules étant insérés longitudinalement dans une baie munie d'une rangée de réceptacles propres chacun à recevoir un module.

Pour illustrer ces propos, on pourra notamment se référer à la demande de brevet européen publiée sous le numéro EP 0 780 932, ainsi qu'aux demandes de brevet français publiées sous les numéros FR 2 709 915, FR 2 778 056 et FR 2 779 901.

La fixation de chaque module dans son réceptacle correspondant doit être aussi rigide que possible, afin d'éviter que d'éventuels chocs dus aux vibrations en vol n'altèrent le bon fonctionnement des circuits (en engendrant des destructions ou même des micro-coupures).

C'est pourquoi on a coutume d'intercaler entre le module et l'une des parois du réceptacle correspondant une cale munie d'un actionneur (généralement sous forme d'une vis ou d'un levier) accessible depuis l'extérieur du réceptacle et dont la manoeuvre provoque une expansion transversale de la cale, plaquant ainsi le module contre une paroi opposée du réceptacle.

De telles cales sont notamment décrites dans les brevets américains délivrés sous les numéros, US 4 821 147, US 4 819 713 et US 5 224 016, ainsi que dans la demande de brevet français publiée sous le numéro FR 2 709 915 précitée (dans cette dernière la cale est intégrée au module).

Les cales connues, telles que décrites notamment dans ces documents, sont généralement réalisées en aluminium, matériau à la fois léger, résistant et présentant une bonne conductibilité thermique. Cette dernière propriété est utile pour l'évacuation des calories générées dans le module par suite de l'échauffement des circuits, celles-ci étant dans un premier temps transmises à la baie par l'intermédiaire de la cale.

D'un point de vue structurel, ces cales comprennent des segments de cales alignés, présentant de manière alternée des surfaces planes destinées à venir en appui contre une paroi du réceptacle et contre une paroi du module. Ces segments de cale sont en appui les uns contre les autres par l'intermédiaire de surfaces biseautées, la compression longitudinale de la cale (c'est-à-dire le rapprochement de ses deux extrémités sous la manoeuvre de son actionneur) provoquant le glissement et le chevauchement des segments de cale les uns par rapport aux autres, et par conséquent l'expansion transversale de la cale.

Ce type de structure, alliée au matériau de la cale, n'est pas sans poser un certain nombre de problèmes.

En premier lieu, le glissement des segments de cale se traduit, au fil du temps, par une usure des surfaces biseautées. Cette usure, inégale, provoque un défaut d'appui des segments et donc un mauvais fonctionnement de la cale. Cette usure, qui accélère par ailleurs la corrosion de la cale, produit en outre une poussière métallique ayant tendance à gripper le glissement des segments de cale les uns par rapport aux autres.

En second lieu, compte tenu de son matériau et de la forme des segments de cale, une telle cale a tendance, lors de l'insertion du module dans son réceptacle, et inversement lors de son extraction de celui-ci, à rayer la surface contre laquelle la cale est en appui, ce qui accélère la corrosion à l'interface entre le module et la cale, où l'apparition de poussière métallique peut en outre provoquer le coincement du module dans son réceptacle, tant lors de son insertion que lors de son extraction.

En troisième lieu, il peut arriver que, dans le cas d'une cale dont l'actionneur se présente sous la forme d'un levier bistable (voir par exemple le brevet américain US 5 224 016 précité), l'épaisseur transversale de la cale en configuration expansée ne corresponde pas à la largeur de l'interstice entre le module et le réceptacle, soit que cette épaisseur soit trop faible (ne permettant pas un maintien suffisant du module), soit qu'elle soit trop importante (ne permettant pas la manoeuvre complète de l'actionneur, ou générant dans la cale des contraintes excessives pouvant notamment entraîner une déformation plastique des segments de cale).

L'invention vise notamment à remédier aux inconvénients précités.

A cet effet, l'invention propose, suivant un premier objet, une cale incluant les caractéristiques de la revendication 1.

Cette cale présente ainsi, de par son aptitude à se rétracter de la zone d'interface avec le module, un risque de coincement et une usure réduits, tant au niveau de la cale elle-même qu'entre la cale et le module dont elle doit assurer le serrage dans le réceptacle correspondant (pour l'application évoquée ci-dessus en introduction). Outre les bénéfices en terme de fiabilité, il en résulte une diminution du risque d'apparition de corrosion au niveau des pièces à serrer.

Suivant un mode de réalisation, l'élément de cale présente une première extrémité fixée à la platine, et une seconde extrémité, mobile par rapport à la platine, couplée audit actionneur, la seconde extrémité étant plus proche de la première extrémité en position active qu'en position inactive.

La platine est de préférence réalisée dans un matériau rigide (tel qu'un plastique rigide), tandis que l'élément de cale est réalisé dans un matériau relativement plus souple (par exemple bi-matière).

Ainsi, suivant un mode de réalisation, l'élément de cale comprend un squelette articulé, réalisé d'un seul tenant dans un matériau semi-rigide (tel qu'un plastique relativement rigide), auquel sont fixés des inserts dans un matériau relativement souple (tel qu'un élastomère).

Par exemple, le squelette de l'élément de cale définit cinq sections successives articulées, séparées par des zones de moindre épaisseur formant charnières au voisinage de chacune desquelles sont disposés des inserts.

Suivant un mode de réalisation, l'élément de cale comprend un insert qui s'étend sensiblement le long d'une section centrale de l'élément de cale.

En outre, la platine peut présenter deux pions de guidage en saillie au droit de sections intermédiaires de l'élément de cale, qui coopèrent avec des gorges pratiquées dans ceux-ci, afin d'éviter des mouvements latéraux indésirables de l'élément de cale.

Suivant un mode de réalisation, l'actionneur est un levier bistable à dépassement de point mort, monté en rotation autour d'un axe fixe par rapport à la platine.

Plus précisément, l'actionneur présente par exemple un bras qui s'étend en porte-à-faux par rapport à l'axe de rotation, ce bras se prolongeant par deux branches, à savoir une première branche fixée par une première extrémité à la platine, et une seconde branche fixée par une seconde extrémité à l'élément de cale, lesdites branches étant déformables entre une position inactive, adoptée en position inactive de l'actionneur, dans laquelle elles définissent une première ouverture angulaire, et une position active, adoptée en position active de l'actionneur, dans laquelle elles définissent une seconde ouverture angulaire supérieure à la première ouverture angulaire, leurs extrémités étant plus proches en position inactive qu'en position active.

En variante, l'actionneur est une vis montée sur une extrémité proximale de la platine et en prise hélicoïdale avec l'élément de cale.

L'invention propose également, suivant un second objet, un système comprenant un module électronique, un réceptacle pour ce module, ainsi qu'au moins une cale telle que décrite ci-dessus, intercalée entre une face latérale du module et une paroi du réceptacle.

Ce système comporte par exemple une poignée de fixation du module au réceptacle, articulée sur une façade du module entre une position de libération dans laquelle elle forme un angle avec la façade, et une position de verrouillage dans laquelle elle s'étend contre la façade en coopérant conjointement avec des moyens d'ancrage prévus sur le réceptacle et avec des moyens de verrouillage prévus sur le module.

De préférence, en position inactive, l'actionneur de la cale est situé sur le trajet de la poignée, de sorte à empêcher le passage de celle-ci de sa position de libération à sa position de verrouillage.

Par ailleurs, suivant un mode de réalisation, les moyens d'ancrage comprennent une pièce d'ancrage présentant un profil en U, qui comprend deux branches longitudinales sensiblement parallèles conformées chacune en ressort de traction, dont une extrémité est accrochée à une patte prévue sur le réceptacle, les branches étant reliées par une âme transversale, et la poignée de fixation du module est articulée autour d'un axe de rotation transversal, et présente une partie d'extrémité s'étendant en porte-à-faux par rapport à l'axe de rotation, cette partie d'extrémité étant munie d'un crochet apte à venir s'engager sur l'âme de la pièce d'ancrage et contraindre celle-ci en traction en position de verrouillage. Les ressorts formant les deux branches longitudinales de la pièce d'ancrage sont de préférence montés en précontrainte afin que l'insertion du module dans le réceptacle puisse s'effectuer selon une force maîtrisée appliquée sur la poignée.

De manière inverse, suivant un mode de réalisation, le crochet précédemment cité pourra prendre appui sur l'âme de la pièce d'encrage alors en butée sur sa patte de fixation prévue sur le réceptacle, de sorte que le porte-à-faux entre le crochet et l'axe de rotation de la poignée permette l'extraction du module du réceptacle.

D'autres objets et avantages de l'invention apparaîtront à la lumière de la description faite ci-après en référence aux dessins annexés dans lesquels :
- la figure 1 est une vue en perspective schématique illustrant un système comprenant un module électronique, un réceptacle dans lequel le module est sur le point d'être inséré, et deux cales montées dans le réceptacle pour le serrage du module dans le réceptacle ;
- la figure 2 est une vue plus détaillée du système de la figure 1, suivant un autre angle de vue ; le module est introduit dans le réceptacle, mais non verrouillé ;
- la figure 3 est une vue similaire à la figure 2, montrant le module verrouillé dans son réceptacle ;
- la figure 4 est une vue de dessus en perspective montrant une cale destinée notamment à être montée dans un réceptacle tel qu'illustré sur les figures 1 à 3 ; la cale est ici représentée dans une configuration inactive ;
- la figure 5 est une vue de dessus en perspective éclatée de la cale de la figure 4 ;
- la figure 6 est une vue en plan de dessus montrant la cale dans sa configuration inactive ;
- la figure 7 est une vue de dessous en perspective éclatée montrant la cale de la figure 4 ;
- la figure 8 est une vue en plan de côté montrant la cale dans sa configuration inactive ;
- la figure 9 est une vue similaire à la figure 4, montrant la cale dans sa configuration active ;
- la figure 10 est une vue analogue à la figure 6, montrant la cale dans sa configuration active ;
- la figure 11 est une vue en coupe montrant la cale de la figure 10 suivant le plan de coupe 11-11 ;
- la figure 12 est une vue constituée d'un assemblage des figures 6 et 8, montrant la cale en position inactive, à gauche du trait mixte en vue de dessus, et à droite du trait mixte en vue de côté ;
- la figure 13 est une vue similaire à la figure 12, constituée d'un assemblage des figures 10 et 11, montrant la cale en position active, à gauche du trait mixte en vue de dessus, et à droite du trait mixte en vue de côté ;
- la figure 14 est une vue d'élévation de côté agrandie montrant un détail du système des figures 1 à 3 ;
- la figure 15 est une vue schématique partielle en plan de dessus montrant le système des figures 1 à 3, dans une position précédant le verrouillage du module dans le réceptacle ; et
- la figure 16 est une vue similaire à la figure 13, montrant le système dans une position où le module est verrouillé dans son réceptacle.

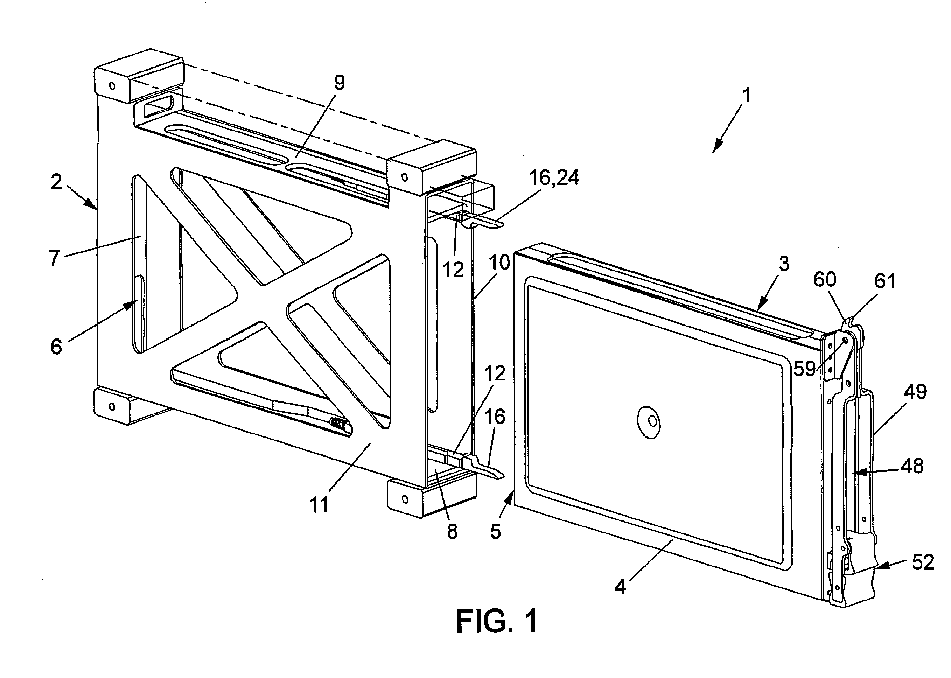

Sur la figure 1 est représenté un système 1 comprenant un réceptacle 2 (fixé individuellement, ou appartenant à une baie comprenant une rangée de réceptacles de ce type) apte à recevoir un module 3 contenant des circuits électroniques. Le module 3 comporte un boîtier 4 parallélépipédique sur une face arrière 5 duquel émerge une connectique (non visible) sur laquelle sont destinés à être branchés des câbles (non représentés) traversant des ouvertures 6 ménagées dans une paroi de fond 7 du réceptacle 2.

Comme cela est visible sur les figures 1 à 3, le réceptacle 2 présente une paroi inférieure 8, sur laquelle le module 3 repose par sa tranche lorsqu'il est introduit dans le réceptacle 2, une paroi supérieure 9 ainsi qu'une première paroi 10 latérale et une seconde paroi 11 latérale toutes deux ajourées, parallèles et définissant entre elles un écartement supérieur à l'épaisseur du module 3.

Ce système 1 comprend en outre au moins une (en l'occurrence deux) cale 12 montée dans le réceptacle 2 à la jonction entre la paroi inférieure 8, respectivement la paroi supérieure 9, et l'une des parois latérales 10, 11.

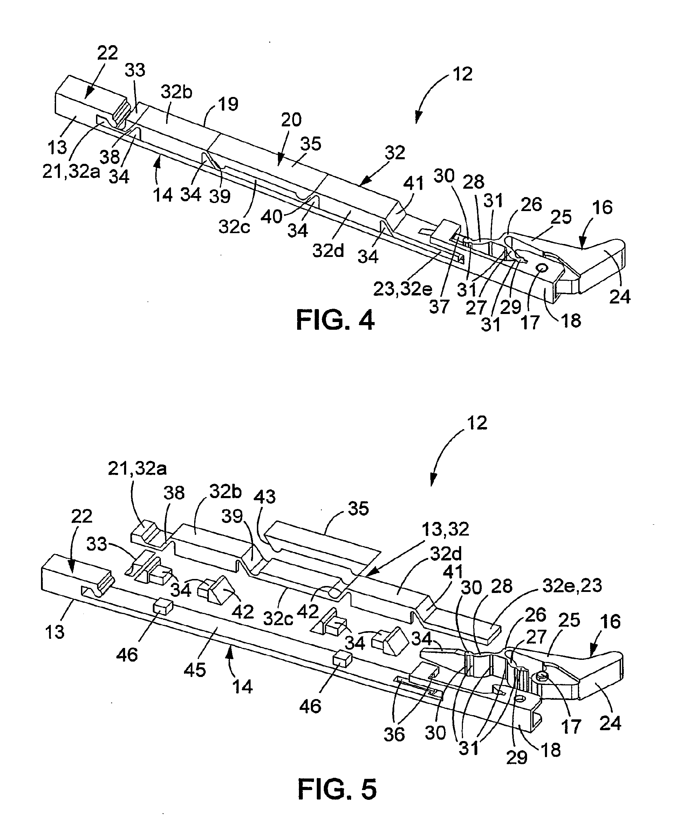

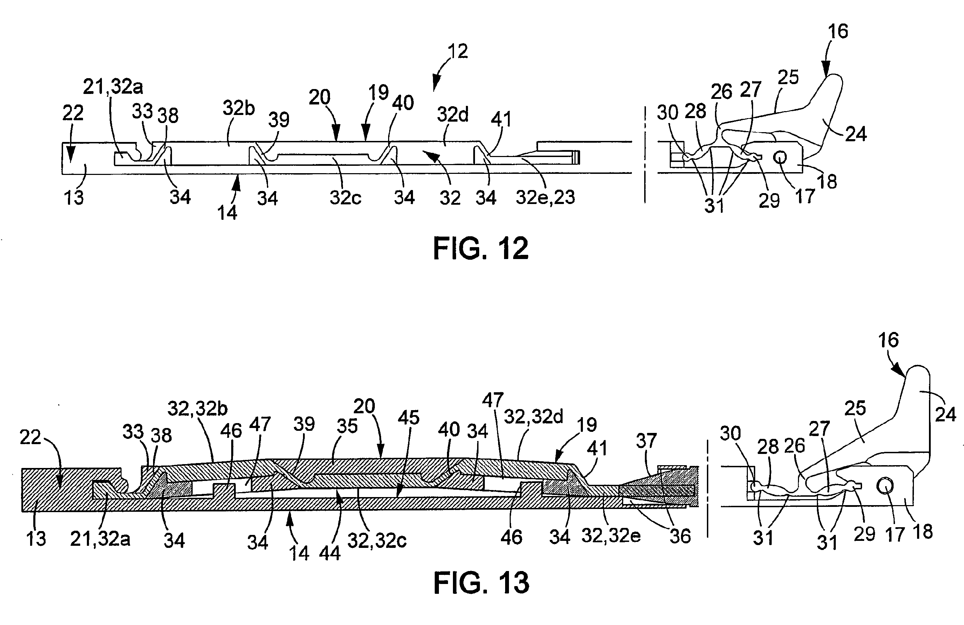

Cette cale 12, représentée seule sur les figures 4 à 13, se présente sensiblement sous la forme d'une barrette longiligne et comporte :
- une platine 13, qui présente une première face d'appui 14 inférieure destinée à être appliquée contre une face latérale 15 du module 3 (ou, au choix de l'installateur, contre la première paroi latérale 10 du réceptacle 2) ;
- un levier 16 bistable à dépassement de point mort, monté sur la platine 13 en étant articulé par rapport à celle-ci autour d'un axe 17 de rotation fixé à une extrémité proximale 18 de la platine 13 conformée en chape, entre une position active et une position inactive ;
- un élément de cale 19 monté sur la platine 13, cet élément de cale 19 ayant une seconde face d'appui 20 supérieure, tournée à l'opposé de la première surface d'appui 14 et destinée à être appliquée contre la première paroi latérale 10 du réceptacle 2 (ou, au choix de l'installateur, contre la face latérale 15 du module 3 en regard).

On notera que les termes « inférieur » et « supérieur » employés pour qualifier les faces 14 et 20, se réfèrent non à la position finale de la cale 12, mais à une position arbitraire telle qu'illustrée sur la figure 1, dans laquelle la cale 12 est en appui par sa face inférieure 14 contre la paroi 10 du réceptacle 2.

L'élément de cale 19 présente une extrémité distale 21 fixée à la platine 13 à proximité d'une extrémité distale 22 de celle-ci, ainsi qu'une extrémité proximale 23, mobile en translation par rapport à la platine 13 en étant couplée au levier 16.

L'élément de cale 19 est déformable par déplacement de son extrémité proximale 23 par rapport à son extrémité distale 21, parallèlement à un axe longitudinale L défini par la platine (confondue en pratique avec une direction d'introduction du module 3 dans son réceptacle 2) sous l'action du levier 16, entre :
- une configuration inactive (que l'on considère plus généralement comme étant une configuration inactive de la cale 12), adoptée en position inactive du levier 16, dans laquelle l'élément de cale 19 s'étend au voisinage de la platine 13 sensiblement parallèlement à celle-ci, ses extrémités 21, 23 définissant entre elles un premier écartement E1, et
- une configuration active (également considérée comme étant plus généralement une configuration active de la cale 12), adoptée en position active du levier 16, dans laquelle l'élément de cale 19 est arc-bouté en étant, au moins dans une partie centrale, écarté de la platine 13, ses extrémités 21, 23 définissant entre elles un second écartement E2 inférieur au premier E1 (E2 < E1), après que sous l'action du levier 16 l'extrémité proximale 23 de l'élément de cale 19 a été déplacée longitudinalement en direction de l'extrémité distale 21.

Le levier 16 est réalisé d'un seul tenant dans une matière plastique ; il comprend un bras de manoeuvre 24, accessible manuellement depuis l'extérieur du réceptacle 2, prolongé par un bras d'actionnement 25 qui s'étend en porte-à-faux par rapport à l'axe de rotation.

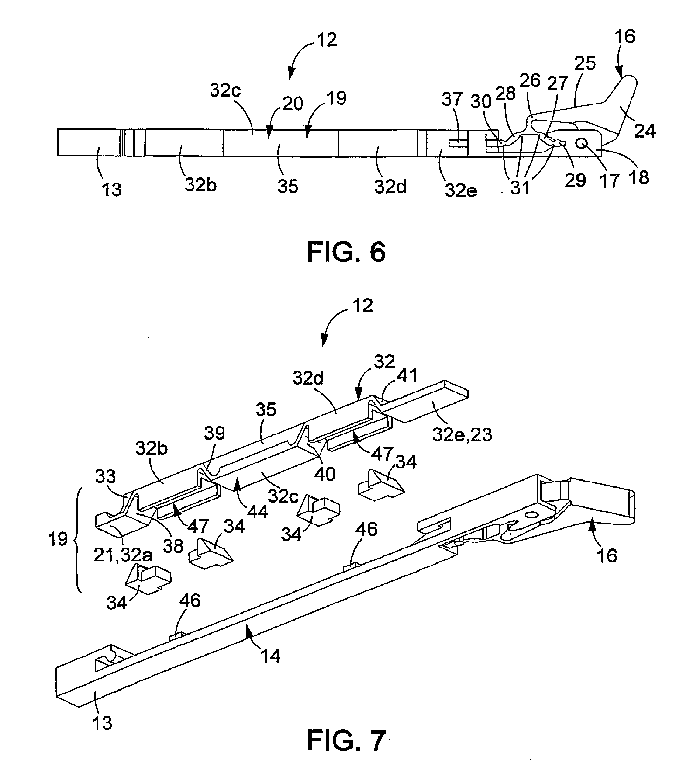

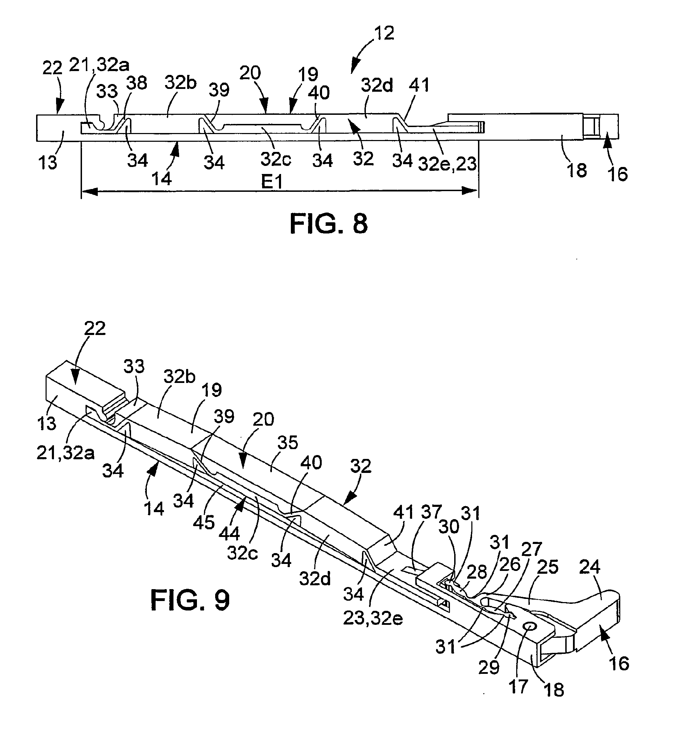

Comme cela est visible sur les figures 4 et 7 notamment, l'axe 17 de rotation du levier 16 est perpendiculaire aux faces d'appui 14 et 20, la course du levier 16 s'effectuant, entre la position inactive représentée sur la figure 4 et la position active représentée sur la figure 9, dans un plan parallèle aux faces d'appui 14 et 20 et perpendiculaire au plan dans lequel s'effectue la déformation de l'élément de cale 19. Cela tient au fait que, une fois la cale 12 en position dans le réceptacle 2, la course du levier 16 doit s'effectuer parallèlement à la paroi latérale 10 du réceptacle 2, tandis que la déformation de l'élément de cale 19 s'effectue perpendiculairement à celle-ci.

Le bras d'actionnement 25 se prolonge, à une extrémité 26 située du côté opposé au bras de manoeuvre 24, par deux branches 27 et 28, à savoir une première branche 27 fixée par une première extrémité 29 à la platine 13, et une seconde branche 28 fixée par une seconde extrémité 30 à l'extrémité proximale 23 de l'élément de cale 19.

A la jonction des branches 27 et 28 avec l'extrémité 26 du bras d'actionnement 25 d'une part, et avec la platine 13 (pour la première branche 27) et l'extrémité proximale 23 de l'élément de cale 19 (pour la seconde branche 28) d'autre part, le levier 16 présente des zones 31 de moindre épaisseur qui s'étendent parallèlement à l'axe 17 de rotation du levier 16, de sorte que les branches 27 et 28 sont déformables en étant articulées entre :
- une configuration inactive, adoptée en position inactive du levier 16, dans laquelle les branches 27 et 28 définissent une première ouverture angulaire (de l'ordre de 120° environ), et
- une configuration active, adoptée en position active de l'actionneur, dans laquelle les branches 27 et 28 définissent une seconde ouverture angulaire (de l'ordre de 180°, c'est-à-dire que les branches 27 et 28 forment un angle sensiblement plat) supérieure à la première ouverture angulaire, leurs extrémités 29, 30 étant par conséquent plus proches en configuration inactive qu'en configuration active.

Suivant un mode de réalisation préféré, la platine 13 est réalisée dans un matériau rigide, tandis que l'élément de cale 19 est au moins partiellement réalisé dans un matériau souple.

Plus précisément, la platine 13 est réalisée dans une matière plastique rigide, tel qu'un polyamide chargé en fibre de verre. On pourra choisir un polyamide 6.6 chargé à 30 % en fibre de verre. Un matériau de ce type est disponible sous l'appellation PA301G6 auprès de la société POLYRAM. Réalisée dans ce matériau, la platine 13 peut aisément être réalisée par injection ou par usinage. La polyamide POLYRAM évoquée ci-dessus présente d'excellentes propriétés mécaniques en relation avec l'utilisation dans le cadre d'une application avionique telle que présentée en introduction de la présente demande. A titre d'information, ces propriétés mécaniques sont résumées dans le tableau ci-dessous :

| **Propriété (Symbole)** | **valeur** | **unité** | **Norme** |
|---|---|---|---|
| Résistance à la traction (Rm) | 135 à 208 | MPa | ISO 527 |
| Allongement à la rupture (A%) | 3 à 5 | % | ISO 527 |
| Résistance à la flexion (σf) | 145 à 240 | MPa | ISO 178 |
| Résistance à la compression (σc) | 200 à 210 | MPa | ISO 604 |
| Module d'élasticité en traction (E) | 7,8 à 10,8 | GPa | ISO 527 |
| Module d'élasticité en flexion (E_{F}) | 5,9 à 8,4 | GPa | ISO 527 |
| Résistance au choc Charpy sans entaille | 88 à 97 | kJ/m² | ISO 179 |
| Résistance au choc Charpy avec entaille | 14 à 16 | kJ/m² | ISO 179 |
| Dureté shore | 80 à 83 | | Echelle D |
| Coefficient de frottement (µ) | 0,3 à 0,35 | | |

Quant à l'élément de cale 19, il est bi-matière et comprend un squelette 32 réalisé dans un matériau plastique relativement rigide, mais tout en étant moins rigide que le matériau dans lequel est réalisée la platine 13, auquel sont fixés des inserts 33, 34, 35 réalisés dans un matériau souple, tel qu'un élastomère, c'est-à-dire plus souple que le squelette 32,.

A titre d'exemple, Pour le squelette 32, on peut utiliser un polypropylène copolymère (également appelé copolymère propylène-éthylène) dont les caractéristiques mécaniques, répondant aux exigences de l'utilisation avionique décrite ci-dessus, sont résumées dans le tableau ci-dessous :

| **Propriété (Symbole)** | **valeur** | **unité** | **Norme** |
|---|---|---|---|
| Résistance à la traction (Rm) | 29 | MPa | ISO 527 |
| Allongement à la rupture (A%) | 50 | % | ISO 527 |
| Module d'élasticité en traction (E) | 1,65 | GPa | ISO 527 |
| Résistance au choc Charpy avec entaille | 7 | kJ/m² | ISO 179 |
| Coefficient de frottement (µ) | 0,1 à 0,3 | | |

Et, pour la réalisation des inserts 33-35, on peut utiliser un élastomère thermoplastique de type styrénique (SEBS), dont les propriétés mécaniques, qui répondent bien à l'utilisation avionique évoquée ci-dessus, sont résumées ci-dessous :

| **Propriété (Symbole)** | **valeur** | **unité** | **Norme** |
|---|---|---|---|
| Résistance à la traction (Rm) | 12 à 25 | MPa | ISO 527 |
| Allongement à la rupture (A%) | 500 à 800 | % | ISO 527 |
| Résistance à la flexion (σf) | 14 à 25 | MPa | ISO 178 |
| Résistance à la compression (σc) | 14 à 25 | MPa | ISO 604 |
| Module d'élasticité en traction (E) | 0,0004 à 0,002 | GPa | ISO 527 |
| Dureté shore | 30 à 95 | | Echelle A |
| Coefficient de frottement (µ) | 0,3 à 0,6 | | |

On pourra constater qu'en comparaison des matériaux de l'élément de cale 19, le matériau utilisé pour la platine 13 présente une grande rigidité, ce qui se traduit par des modules d'élasticité en traction et en flexion sensiblement plus élevés (dans un rapport de 1000 à 1, voire 10000 à 1 environ vis-à-vis du matériau des inserts 33-35 et dans un rapport de 5 à 1 environ vis-à-vis du matériau du squelette 32) et des résistances à la traction et à la flexion également plus élevés, tout du moins vis-à-vis du matériau des inserts 33-35 (dans un rapport de 10 à 1). L'une des conséquences de ces caractéristiques est la possibilité de réaliser une platine 13 d'épaisseur relativement réduite, au bénéfice de la compacité et de la légèreté de la cale 12.

S'agissant du matériau dans lequel est réalisé le squelette 32, il présente comme on peut le constater une bonne déformabilité (son allongement à la rupture étant dans un rapport de 10 à 1 vis-à-vis du matériau de la platine 13) tout en ayant une bonne résistance à la traction (dans un rapport de 1 à 6 seulement vis-à-vis du matériau de la platine 13).

Enfin, les propriétés du matériau dans lequel sont réalisés les inserts 33-35 leur confèrent une excellente déformabilité élastique en flexion, sans risque de rupture en fatigue (son allongement à la rupture étant dans un rapport de 100 à 1 vis-à-vis du matériau de la platine 13) de sorte à pouvoir se déformer lors de l'actionnement du levier 16, tout en ayant une bonne résistance vis-à-vis du matériau du squelette 32 (son allongement à la rupture étant dans un rapport de 10 à 1 vis-à-vis du matériau du squelette 32), afin que la déformation générale de l'élément de cale 19 puisse se faire suivant une forme prédéterminée, comme nous le verrons ci-après.

Par ailleurs, l'élément de cale 19 étant de préférence réalisé par surmoulage, l'on choisira de préférence pour les inserts 33-35 un élastomère ayant de bonnes qualités d'adhésion sur le matériau du squelette 32. Les exemples fournis ci-dessus remplissent cette condition.

Comme cela est visible sur les figures 4 et 5 notamment, le squelette 32 de l'élément de cale 19 définit cinq sections 32a-32e successives, à savoir :
- une première section d'extrémité 32a, formant l'extrémité distale 21 de l'élément de cale 19, fixée, comme nous l'avons vu, à la platine 13 à l'extrémité distale 22 de celle-ci,
- une première section intermédiaire 32b,
- une section centrale 32c,
- une seconde section intermédiaire 32d, et
- une seconde section d'extrémité 32e, formant l'extrémité proximale 23 de l'élément de cale 19, et couplée, comme nous l'avons vu, au levier 16 en étant fixée à la seconde branche 28 de celui-ci.

Le guidage longitudinal de l'extrémité proximale 23 de l'élément de cale 19 est réalisé au moyen d'une rainure 36 pratiquée dans la platine 13, dans laquelle coulisse une patte 37 formant le raccord entre le levier 16 et l'élément de cale 19.

Ces sections 32a-32e sont séparées deux à deux par des zones de moindre épaisseur 38, 39, 40, 41 formant charnières, autour desquelles les sections 32a-32e sont articulées, des inserts 33, 34 étant disposés au voisinage et de part et d'autre de chaque charnière 38-41.

Plus précisément, comme cela est visible sur les figures 4 et 9, l'élément de cale 19 comprend un insert central 35 qui s'étend sensiblement le long de la section centrale 32c, d'une charnière 39 à l'autre 40, et qui y forme localement la face supérieure 20 d'appui de l'élément de cale 19.

Les figures 5 et 7 montrent que chaque zone de moindre épaisseur 38-41 formant une charnière du squelette 32 est constituée par une fine bande de matière souple, inclinée par rapport à l'axe longitudinal L, prise entre deux faces parallèles en regard 42, 43 des inserts 33-35 situés de part et d'autre de la charnière 38-41.

En résumé, comme cela est visible sur la figure 5, la première section d'extrémité 32a comprend un insert 33 situé du côté de la face supérieure 20 de l'élément de cale 19 ; les sections intermédiaires 32b, 32d comprennent chacune deux inserts 34 situés du côté d'une face inférieure 44 de l'élément de cale 19 opposée à l'opposé de la face supérieure 20 (cette face inférieure 44 étant en contact avec une face supérieure 45 de la platine 13 en position inactive de l'élément de cale 19) ; la section centrale 32c comprend l'insert central 35 ; enfin, la seconde section d'extrémité 32e comprend un insert identique à la section 32a (non représenté sur la figure (ces deux inserts d'extrémité, ne travaillant pas en compression, étant d'ailleurs optionnels).

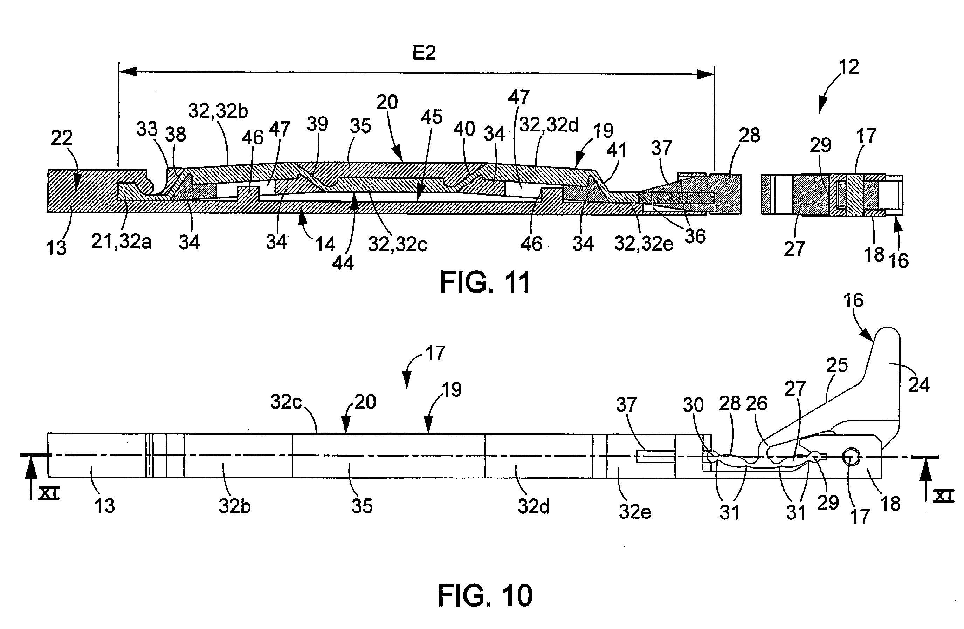

Il résulte de ces caractéristiques combinées de structure (qui viennent d'être décrites) et de matériau (décrites ci-dessus), que l'élément de cale 19 adopte, grâce à son articulation souple :
- dans sa configuration inactive une forme sensiblement rectiligne (figures 4 et 8), et
- dans sa configuration active une forme sensiblement en U ouvert (figures 9 et 11), avec la section centrale 32c à distance de la platine 13.

Dans la configuration active, les inserts 34 sont comprimés élastiquement, tandis que l'insert central 35 est fléchi élastiquement : sous l'effet de l'élasticité des inserts 34, 35, l'élément de cale 19 est sollicité en permanence vers sa configuration inactive, qu'il tend donc à adopter automatiquement lorsque le levier 16 est basculé vers sa position inactive.

Afin d'éviter qu'en configuration active l'élément de cale 19 ne se désaxe latéralement par rapport à la platine 13, celle-ci présente deux pions de guidage 46 en saillie sur la face supérieure 45, situés au droit des sections intermédiaires 32b, 32d, ces pions 46 coopérant avec des gorges 47 pratiquées dans les sections intermédiaires 32b, 32d du côté de la face inférieure 44 de l'élément de cale 19. Ainsi, quelle que soit la configuration de l'élément de cale 19, les mouvements latéraux de l'élément de cale 19 ne sont pas autorisés, celui-ci étant assujetti à se déformer dans un plan à la fois perpendiculaire à sa surface d'appui 14 et contenant l'axe longitudinal L de la cale 12.

La cale 12 qui vient d'être présentée permet d'assurer un serrage doux du module 3 dans son réceptacle 2, c'est-à-dire que, compte tenu des matériaux dans lesquels la cale 12 est réalisée, et notamment l'élastomère très souple de l'insert central 35, son contact avec le module 3 et le réceptacle 2 ne provoque ni usure ni rayure à l'interface. Il en résulte un ralentissement sensible de l'apparition de corrosion, la cale 12 y étant d'ailleurs elle-même insensible.

La cale 12 ne présente quasiment aucun risque de coincement, et ce quelles que soient les forces mises en jeu lors du serrage du module 3 dans le réceptacle 2, le seul frottement de glissement se produisant entre l'extrémité proximale 23 de l'élément de cale 19 et la platine 13. Compte tenu des faibles coefficients de frottement des matériaux dans lesquels est réalisée la cale 12, le frottement de glissement entre la platine 13 et l'élément de cale 19 a une incidence très faible, voire nulle, sur le bon fonctionnement de la cale 12.

Le caractère maîtrisé de la déformation de l'élément de cale 19, indéfiniment reproductible, et possédant néanmoins une bonne compliance (c'est-à-dire une capacité de s'ajuster aux contraintes et aux forces qui s'exercent sur lui et de corriger ainsi les erreurs de positionnement et d'orientation engendrées par ces contraintes et ces forces), permet d'assurer un appui sensiblement uniforme de la cale 12 sur le module 3, et donc du module 3 contre la seconde paroi latérale 11 du réceptacle 2, et favorise ainsi l'évacuation par celle-ci des calories générées par le fonctionnement du module 3, compensant ainsi le caractère thermiquement isolant des matériaux choisis pour la cale 12, dont on aurait pourtant pu supposer, *a priori,* qu'elle nuirait au drainage thermique.

En outre, la souplesse de l'élément de cale 19 lui permet d'absorber, d'une part, le surplus inutile de contrainte généré par un éventuel serrage trop important du module 3 et, d'autre part, au moins une partie des chocs et vibrations subies en vol par le système 1.

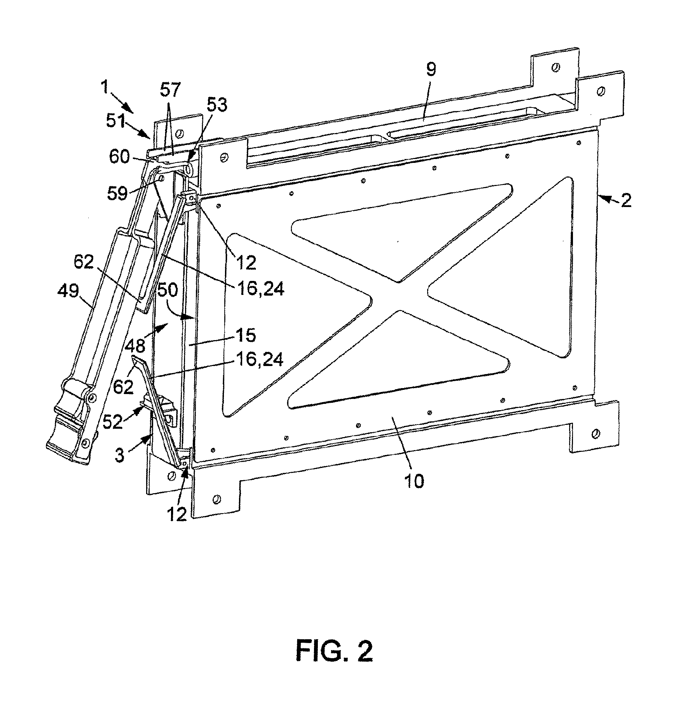

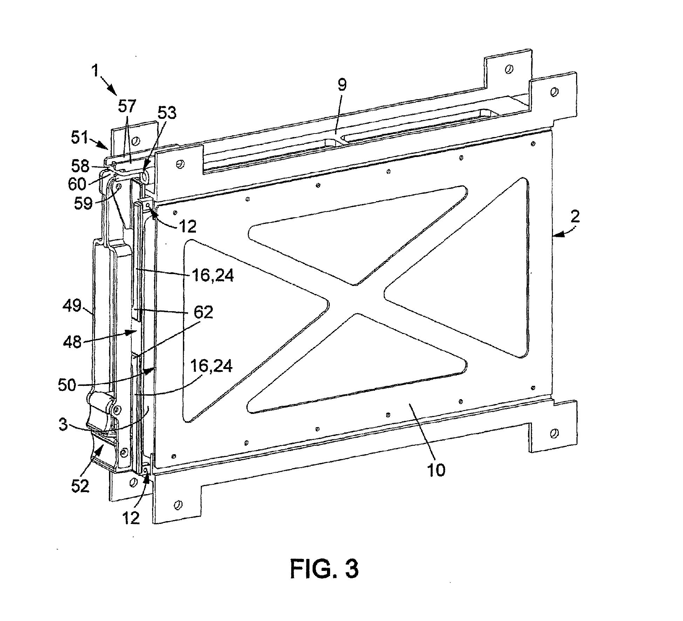

Comme cela est visible sur les figures 2 et 3, le module 3 est muni sur une façade 48 d'une poignée 49 de fixation articulée sur la façade 48 entre une position de libération dans laquelle elle forme un angle avec la façade 48 (figure 2), et une position de verrouillage dans laquelle elle s'étend contre celle-ci (figure 3).

Le serrage du module 3 dans son réceptacle 2 est effectué comme suit.

On commence par introduire le module 3 dans le réceptacle 2, les deux cales 12 intercalées entre eux étant dans leur configuration inactive, dans laquelle leur épaisseur est inférieure à la largeur d'un interstice 50 prévu entre la première paroi latérale 10 du réceptacle 2 et le module 3, de manière à ne pas gêner l'introduction de ce dernier.

On actionne alors la poignée 49 pour permettre l'insertion complète du module 3 dans le réceptacle 2

Puis on verrouille définitivement le module 3 dans le réceptacle 2 en actionnant la poignée 49 de fixation pour la placer dans sa position de verrouillage dans laquelle elle vient coopérer conjointement avec des moyens d'ancrage 51 prévus sur le module 3 et avec des moyens de verrouillage 52 prévus sur la façade 48 du module 3.

On actionne enfin les leviers 16 vers leur position active pour placer les cales 12 en configuration active et ainsi assurer le serrage du module 3 dans son réceptacle 2.

Cette dernière action peut être entreprise avant le verrouillage complet de la poignée 49, mais nécessairement après l'insertion complète du module 3 dans son réceptacle 2.

Comme cela est visible sur les figures 2 et 3, les moyens d'ancrage 51 comprennent une pièce d'ancrage 53 présentant un profil en U, montée sur la paroi supérieure 9 du réceptacle 2.

Cette pièce d'ancrage 53 comprend deux branches 54, 55 longitudinales sensiblement parallèles conformées chacune en ressort de traction, dont une extrémité 56 recourbée en crochet est accrochée à une patte 57 prévue en saillie sur la paroi supérieure 9 du réceptacle 2.

Les branches 54, 55 sont reliées par une âme 58 transversale qui s'étend à l'aplomb de la façade 48 du module 3 lorsque celui-ci se trouve dans le réceptacle 2.

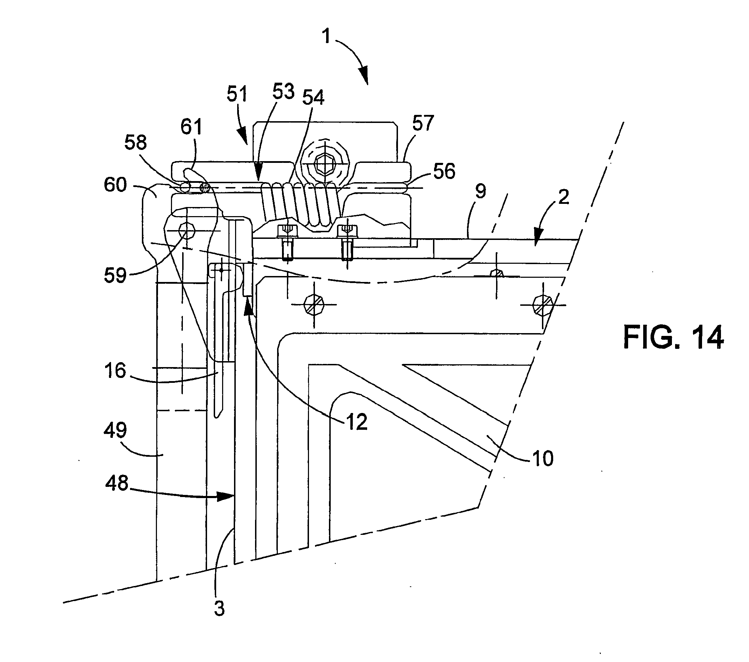

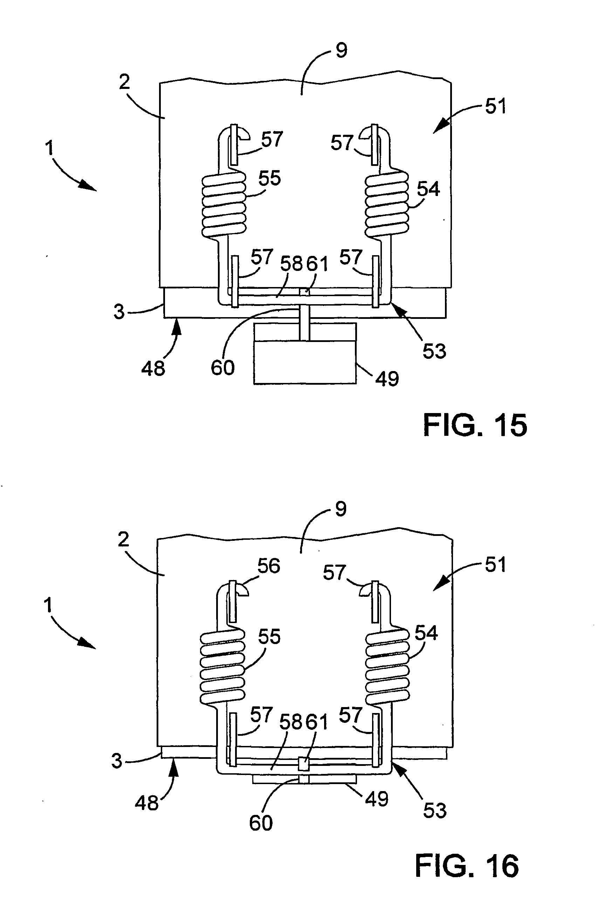

Comme cela est visible sur les figures 2, 3 et 14, la poignée 49 est articulée autour d'un axe 59 de rotation transversal ; elle présente une partie d'extrémité 60 qui, s'étendant en porte-à-faux par rapport à l'axe 59 du côté de la pièce d'ancrage 53, est munie d'un crochet 61 qui, une fois le module 3 introduit dans le réceptacle 2 (figures 2, 15), vient s'engager sur l'âme 58 pour contraindre la pièce d'ancrage 53 en traction lorsque la poignée 49 bascule en position de verrouillage (figures 3, 16).

Les ressorts constitués des branches 54, 55 de la pièce d'encrage 53 sont tendus au montage sur la patte 57 de telle sorte que l'effort nécessaire à son élongation complémentaire sous l'action de l'extrémité 60 de la poignée 49 sur l'âme 58 ne puisse avoir lieu qu'au delà de l'effort maximal à appliquer sur le module 3 pour assurer son engagement complet dans le réceptacle 2.

Les moyens de verrouillage 52 ne seront pas décrits en détail : on pourra se reporter au document EP 0 780 932 précité.

Afin d'améliorer la fiabilité du système 1, il est possible de subordonner le verrouillage du module 3 dans le réceptacle 2 (par l'actionnement de la poignée 49, comme nous venons de le voir) à son serrage au moyen des cales 12. A cet effet, et comme cela est illustré sur les figures 2 et 3, chaque levier 16 s'étend au moins en partie sur le trajet de la poignée 49, de sorte à empêcher le passage de celle-ci de sa position de libération à sa position de verrouillage sans que les leviers 16 aient auparavant été actionnés.

Plus précisément, l'on peut parvenir à ce résultat en munissant le bras de manoeuvre 24, par exemple à son extrémité libre, comme cela est illustré sur les figures 2 et 3, d'une patte 62 en saillie transversale (le bras ayant ainsi sensiblement une forme de L) contre laquelle la poignée 49 vient buter lors de son basculement et qu'elle entraîne avec elle, actionnant ainsi les leviers 16. Il est à noter qu'une telle disposition permet, en procédant au verrouillage du module 3 dans le réceptacle 2, d'achever simultanément son serrage.

Inversement, l'appui de la partie d'extrémité 60 sur l'âme 58 de la pièce d'ancrage 53 permet d'appliquer, par l'intermédiaire de la poignée 49, l'effort sur le module 3 nécessaire à son désengagement du réceptacle 2.

Un autre avantage d'une telle configuration est de fiabiliser le maintien du module 3 dans son réceptacle 2. En effet, en cas de défaillance du système de verrouillage 52, qui assure le maintien de la poignée 49 en position, celle-ci se trouverait effectivement libérée, mais les leviers 16 des cales 12 resteraient quant à eux en position active dans la mesure où cette position est stable. Le module 3 resterait alors plaqué contre la face 11 du réceptacle 2, empêchant ainsi son désengagement.

## Revendications

1. Cale (12) pour assurer le serrage d'un module électronique (3) dans un réceptacle (2), se présentant sensiblement sous la forme d'une barrette longiligne et comportant :
- une platine (13) ;
- un actionneur (16) fixé à une extrémité proximale (18) de la platine (13) en étant mobile par rapport à ladite platine entre une position active et une position inactive ;
- un élément de cale (19) monté sur la platine (13) et couplé audit actionneur (16), l'élément de cale (19) présentant une extrémité distale (21) fixée à la platine (13) à proximité d'une extrémité distale (22) de ladite platine (13), ainsi qu'une extrémité proximale (23), mobile en translation par rapport à la platine (13),
**caractérisée en ce que**
la platine (13) présente une face d'appui (14) destinée à être appliquée soit contre une face latérale (15) du module (3), soit contre une paroi latérale (10) du réceptacle (2) ;
l'élément de cale (19) présente une face d'appui (20), tournée à l'opposé de ladite face d'appui (14) de ladite platine (13), et destinée à être appliquée soit contre ladite paroi latérale (10) du réceptacle, soit contre ladite face latérale (15) du module (3) en regard ;
l'actionnement de l'actionneur provoque la déformation de l'élément de cale (19) est déformable entre :
- une configuration inactive, adoptée en position inactive de l'actionneur (16), dans laquelle l'élément de cale (19) s'étend au voisinage de la platine (13), et une configuration active, adoptée en position active de l'actionneur (16), dans laquelle l'élément de cale (19) est arc-bouté en étant au moins localement écarté de la platine (13), l'actionnement de l'actionneur (16) provoquant l'arc-boutement dudit élément de cale (19) et l'application de ladite face d'appui (14) de ladite platine (13) soit contre la paroi latérale (10) du réceptacle (2), soit contre la face latérale (15) du module (3) en regard, avec pour effet de serrer le module électronique (3) dans le réceptacle (2), et **en ce que**, afin de permettre l'arc-boutement de l'élément de cale (19), la platine (13) est réalisée dans un matériau rigide, tandis que l'élément de cale (19) comprend un squelette (32), réalisé d'un seul tenant dans un matériau moins rigide que le matériau dans lequel est réalisé la platine (13), squelette (32) auquel sont fixés des inserts (33, 34, 35) dans un matériau plus souple que celui du squelette (32).

2. Cale (12) selon la revendication 1, dans laquelle ladite extrémité proximale (23) dudit élément de cale (19) est apte à être mise en translation lors de l'actionnement de l'actionneur (16).

3. Cale (12) selon la revendication 1 ou 2, dans laquelle l'extrémité proximale (23) de l'élément de cale (19) est plus proche de l'extrémité distale (21) de l'élément de cale (19) en configuration active qu'en configuration inactive.

4. Cale (12) selon l'une quelconque des revendications précédentes, dans laquelle le squelette (32) de l'élément de cale (19) définit cinq sections (32a-32e) successives articulées, séparées par des zones (38-41) de moindre épaisseur formant charnières, et dans laquelle des inserts (33-35) sont disposés au voisinage de chaque charnière (38-41).

5. Cale (12) selon l'une quelconque des revendications précédentes, dans laquelle l'élément de cale (19) comprend un insert (35) qui s'étend sensiblement le long d'une section centrale (32c) de l'élément de cale (19).

6. Cale (12) selon la revendication 4 ou 5, dans laquelle la platine (13) présente deux pions (46) de guidage en saillie au droit de sections intermédiaires (32b, 32d) de l'élément de cale (19), et qui coopèrent avec des gorges (47) pratiquées dans ceux-ci.

7. Cale (12) selon l'une quelconque des revendications précédentes, dans laquelle le squelette (32) est réalisé dans une matière plastique relativement rigide, les inserts (33-35) étant réalisés dans un élastomère.

8. Cale (12) selon la revendication 7, dans laquelle l'élément de cale (19) est réalisé par surmoulage.

9. Cale (12) selon l'une quelconque des revendications précédentes, dans laquelle la platine (13) est réalisée dans une matière plastique rigide.

10. Cale (12) selon l'une quelconque des revendications précédentes, dans laquelle l'actionneur (16) est un levier bistable à dépassement de point mort, monté en rotation autour d'un axe (17) fixe par rapport à la platine (13).

11. Cale (12) selon la revendication précédente, dans laquelle l'actionneur (16) présente un bras (25) qui s'étend en porte-à-faux par rapport à l'axe (17) de rotation du levier (16), ce bras (25) présentant une extrémité (26) à laquelle se raccordent deux branches (27, 28), à savoir une première branche (27) fixée par une première extrémité (29) à la platine (13), et une seconde branche (28) fixée par une seconde extrémité (30) à l'élément de cale (19), lesdites branches (27, 28) étant déformables entre une configuration inactive, adoptée en position inactive de l'actionneur (16), dans laquelle elles définissent une première ouverture angulaire, et une configuration active, adoptée en position active de l'actionneur (16), dans laquelle elles définissent une seconde ouverture angulaire supérieure à la première ouverture angulaire, leurs extrémités (29, 30) étant plus proches en configuration inactive qu'en configuration active.

12. Cale (12) selon l'une quelconque des revendications 1 à 10, dans laquelle l'actionneur (16) est une vis montée sur une extrémité proximale de la platine (13) et en prise hélicoïdale avec l'élément de cale (19).

13. Système (1) comprenant
- un module (3) électronique ;
- un réceptacle (2) pour ledit module (3) ;
- au moins une cale (12) selon l'une des revendications 1 à 12, intercalée entre une face latérale (15) du module (3) électronique et une paroi latérale (10) du réceptacle (2).

14. Système (1) selon la revendication 13, qui comprend une poignée (49) de fixation du module (3) au réceptacle (2), cette poignée (49) étant articulée sur une façade (48) du module (3) entre une position de libération dans laquelle elle forme un angle avec la façade (48), et une position de verrouillage dans laquelle elle s'étend contre la façade (48) en coopérant conjointement avec des moyens d'ancrage (51) prévus sur le réceptacle (2) et avec des moyens de verrouillage (52) prévus sur le module (3).

15. Système (1) selon la revendication 14, dans lequel, en position inactive, l'actionneur (16) de la cale (12) est situé sur le trajet de la poignée (49), de sorte à empêcher le passage de celle-ci de sa position de libération à sa position de verrouillage.

16. Système (1) selon la revendication 14 ou 15, dans lequel les moyens d'ancrage (51) comprennent une pièce d'ancrage (53) présentant un profil en U, qui comprend deux branches (54, 55) longitudinales sensiblement parallèles conformées chacune en ressort de traction, dont une extrémité (56) est accrochée à une patte (57) prévue sur le réceptacle (2), les branches (54, 55) étant reliées par une âme (58) transversale, et dans lequel la poignée (49) de fixation du module (3) est articulée autour d'un axe (59) de rotation transversal, et présente une partie d'extrémité (60) s'étendant en porte-à-faux par rapport à l'axe (59) de rotation, cette partie d'extrémité (60) étant munie d'un crochet (61) apte à venir s'engager sur l'âme (58) de la pièce d'ancrage (53) et contraindre celle-ci en traction en position de verrouillage.

## Claims

1. Wedge (12) for clamping an electronic module (3) in a receptacle (2), being substantially in the form of a long bar and comprising:
- a plate 13;
- an actuator (16) fixed to a proximal end (18) of the plate (13) and being movable relative to said plate between an active position and an inactive position;
- a wedge member (19) mounted on the plate (13) and coupled to said actuator (16), the wedge member (19) having a distal end (21) fixed to the plate (13) adjacent to a distal end (22) of said plate (13), and also a proximal end (23), movable in translation relative to the plate (13),
**characterized in that**
the plate (13) has a bearing face (14) intended to be applied either against a lateral face (15) of the module (3), or against a lateral wall (10) of the receptacle (2) ;
the wedge member (19) has a bearing face (20), turned the opposite way from said bearing face (14) of said plate (13), and intended to be applied either against said lateral wall (10) of the receptacle or against said lateral face (15) of the module (3) opposite;
the actuation of the actuator brings about the deformation of the wedge member (19) which is deformable between:
- an inactive configuration, adopted in the inactive position of the actuator (16), in which the wedge member (19) extends in the vicinity of the plate (13), and
- an active configuration, adopted in the active position of the actuator (16), wherein the wedge member (19) is braced by being at least locally distanced from the plate (13), the actuation of the actuator (16) bringing about the bracing of said wedge member (19) and the application of said bearing face (14) of said plate (13) either against the lateral wall (10) of the receptacle (2) or against the lateral face (15) of the module (3) opposite, having the effect of clamping the electronic module (3) in the receptacle (2), and **in that**, in order to permit the bracing of the wedge member (19), the plate (13) is made of a rigid material, whereas the wedge member (19) comprises a skeleton (32), made in one piece in a material less rigid than the material from which the plate (13) is made, to which skeleton (32) are fixed inserts (33, 34, 35) of a material more flexible than that of the skeleton (32).

2. Wedge (12) according to claim 1, wherein said proximal end (23) of said wedge member (19) is suitable for being moved in translation during the actuation of the actuator (16).

3. Wedge (12) according to claim 1 or 2, wherein the proximal end (23) of the wedge member (19) is closer to the distal end (21) of the wedge member (19) in the active configuration than in the inactive configuration.

4. Wedge (12) according to any one of the preceding claims, wherein the skeleton (32) of the wedge member (19) defines five consecutive articulated sections (32a-32e), separated by zones (38-41) of lesser thickness forming hinges, and wherein inserts (33-35) are arranged in the vicinity of each hinge (38-41).

5. Wedge (12) according to any one of the preceding claims, wherein the wedge member (19) comprises an insert (35) which extends substantially along a central section (32c) of the wedge member (19).

6. Wedge (12) according to claim 4 or 5, wherein the plate (13) has two guide studs (46) protruding opposite intermediate sections (32b, 32d) of the wedge member (19), and which co-operate with grooves (47) provided in these latter.

7. Wedge (12) according to any one of the preceding claims, wherein the skeleton (32) is made of a relatively rigid plastics material, the inserts (33-35) being made of an elastomer.

8. Wedge (12) according to claim 7, wherein the wedge member (19) is produced by overmoulding.

9. Wedge (12) according to any one of the preceding claims, wherein the plate (13) is made of a rigid plastics material.

10. Wedge (12) according to any one of the preceding claims, wherein the actuator (16) is an over dead centre bistable lever, mounted in rotation about an axis (17) fixed with respect to the plate (13).

11. Wedge (12) according to the preceding claim, wherein the actuator (16) has an arm (25) which is cantilevered with respect to the axis of rotation (17) of the lever (16), the arm (25) having an end (26) to which two limbs (27, 28) are connected, i.e. a first limb (27) fixed by a first end (29) to the plate (13), and a second limb (28) fixed by a second end (30) to the wedge member (19), said limbs (27, 28) being deformable between an inactive configuration, adopted in the inactive position of the actuator (16) and in which they define a first angular opening, and an active configuration, adopted in the active position of the actuator (16) and in which they define a second angular opening higher than the first angular opening, their ends (29, 30) being closer in the inactive configuration than in the active configuration.

12. Wedge (12) according to any one of claims 1 to 10, wherein the actuator (16) is a screw mounted on a proximal end of the plate (13) and in helical engagement with the wedge member (19).

13. System (1) comprising
- an electronic module (3);
- a receptacle (2) for said module (3);
- at least one wedge (12) according to any one of claims 1 to 12, interposed between a lateral face (15) of the electronic module (3) and a lateral wall (10) of the receptacle (2).

14. System (1) according to claim 13, which comprises a handle (49) for fixing the module (3) to the receptacle (2), the handle (49) being articulated on a face portion (48) of the module (3) between a release position in which it forms an angle with the face portion (48), and a locking position in which it extends against the face portion (48) while co-operating conjointly with an anchorage means (51) provided on the receptacle (2) and with a locking means (52) provided on the module (3).

15. System (1) according to claim 14, wherein, in the inactive position, the actuator (16) of the wedge (12) is located in the path of the handle (49), in such a way as to prevent the passage of this latter from its release position to its locking position.

16. System (1) according to claim 14 or 15, wherein the anchorage means (51) comprises an anchorage member (53) having a U-shaped profile, and which comprises two longitudinal limbs (54, 55), substantially parallel, each configured as a tension spring, one end (56) of which is hooked on to a lug (57) provided on the receptacle (2), the limbs (54, 55) being connected by a transverse core (58), and wherein the handle (49) for fixing the module (3) is articulated about an axis of transverse rotation (59), and has an end portion (60) cantilevered relative to the axis of rotation (59), the end portion (60) being equipped with a hook (61) suitable for engaging on the core (58) of the anchorage member (53) and constraining this latter in tension in the locking position.

## Patentansprüche

1. Keil (12) zur Gewährleistung des Festklemmens eines elektronischen Moduls (3) in einer Aufnahme (2), der im Wesentlichen in Form eines langgestreckten Stegs vorliegt und Folgendes aufweist:
- eine Grundplatte (13);
- ein an einem proximalen Ende (18) der Grundplatte (13) befestigtes Betätigungsglied (16), das dabei bezüglich der Grundplatte zwischen einer aktiven Position und einer inaktiven Position beweglich ist;
- ein an der Grundplatte (13) angebrachtes Keilelement (19), das mit dem Betätigungsglied (16) verbunden ist, wobei das Keilelement (19) ein distales Ende (21), das in der Nähe eines distalen Endes (22) der Grundplatte (13) an der Grundplatte (13) befestigt ist, sowie ein proximales Ende (23), das bezüglich der Grundplatte (13) translatorisch beweglich ist, aufweist,
**dadurch gekennzeichnet, dass**
die Grundplatte (13) eine Stützfläche (14) aufweist, die dazu bestimmt ist, gegen eine Seitenfläche (15) des Moduls (3) oder gegen eine Seitenwand (10) der Aufnahme (2) gedrückt zu werden;
das Keilelement (19) eine Stützfläche (20) aufweist, die von der Stützfläche (14) der Grundplatte (13) weg weist und dazu bestimmt ist, gegen die Seitenwand (10) der Aufnahme oder gegen die gegenüberliegende Seitenfläche (15) des Moduls (3) gedrückt zu werden;
die Betätigung des Betätigungsglieds die Verformung des Keilelements (19) bewirkt, das sich zwischen:
- einer inaktiven Konfiguration, die in der inaktiven Position des Betätigungsglieds (16) eingenommen wird und in der sich das Keilelement (19) in der Nähe der Grundplatte (13) erstreckt, und
- einer aktiven Konfiguration, die in der aktiven Position des Betätigungsglieds (16) eingenommen wird und in der das Keilelement (19) verstrebt und dabei zumindest lokal von der Grundplatte (13) entfernt ist, verformen kann, wobei die Betätigung des Betätigungsglieds (16) die Verstrebung des Keilelements (19) und das Drücken der Stützfläche (14) der Grundplatte (13) gegen die Seitenwand (10) der Aufnahme (2) oder gegen die gegenüberliegende Seitenfläche (15) des Moduls (3) bewirkt, was zum Festklemmen des elektronischen Moduls (3) in der Aufnahme (2) führt, und dass zum Gestatten der Verstrebung des Keilelements (19) die Grundplatte (13) aus einem starren Material hergestellt ist, während das Keilelement (19) ein Gerüst (32) umfasst, das in einem Stück aus einem weniger starren Material hergestellt ist als das Material, aus dem die Grundplatte (13) hergestellt ist, wobei an dem an dem Gerüst (32) Einsätze (33, 34, 35) aus einem flexibleren Material als das des Gerüsts (32) angebracht sind.

2. Keil (12) nach Anspruch 1, bei dem das proximale Ende (23) des Keilelements (19) bei der Betätigung des Betätigungsglieds (16) translatorisch bewegt werden kann.

3. Keil (12) nach Anspruch 1 oder 2, bei dem sich das proximale Ende (23) des Keilelements (19) näher dem distalen Ende (21) des Keilelements (19) in der aktiven Konfiguration als in der inaktiven Konfiguration befindet.

4. Keil (12) nach einem der vorhergehenden Ansprüche, bei dem das Gerüst (32) des Keilelements (19) fünf aufeinander folgende, angelenkte Abschnitte (32a - 32e) definiert, die durch Zonen (38 - 41) geringerer Dicke, die Gelenke bilden, getrennt sind, und bei dem Einsätze (33 - 35) in der Nähe jedes Gelenks (38 - 41) angeordnet sind.

5. Keil (12) nach einem der vorhergehenden Ansprüche, bei dem das Keilelement (19) einen Einsatz (35) umfasst, der sich im Wesentlichen entlang einem mittleren Abschnitt (32c) des Keilelements (19) erstreckt.

6. Keil (12) nach Anspruch 4 oder 5, bei dem die Grundplatte (13) zwei Führungszapfen (46) aufweist, die im Bereich Zwischenabschnitte (32b, 32d) des Keilelements (19) vorragen und mit darin ausgebildeten Kehlen (47) zusammenwirken.

7. Keil (12) nach einem der vorhergehenden Ansprüche, bei dem das Gerüst (32) aus einem relativ starren Kunststoffmaterial hergestellt ist, wobei die Einsätze (33 - 35) aus einem Elastomer hergestellt sind.

8. Keil (12) nach Anspruch (7), bei dem das Keilelement (19) durch Aufspritzen hergestellt ist.

9. Keil (12) nach einem der vorhergehenden Ansprüche, bei dem die Grundplatte (13) aus einem starren Kunststoffmaterial hergestellt ist.

10. Keil (12) nach einem der vorhergehenden Ansprüche, bei dem das Betätigungsglied (16) ein drehbar um eine bezüglich der Grundplatte (13) festgelegte Achse (17) angebrachter bistabiler Übertotpunkthebel ist.

11. Keil (12) nach dem vorhergehenden Anspruch, bei dem das Betätigungsglied (16) einen Arm (25) aufweist, der sich freiragend bezüglich der Achse (17) des Drehhebels (16) erstreckt, wobei dieser Arm (25) ein Ende (26), mit dem zwei Schenkel (27, 28), nämlich ein mit einem ersten Ende (29) an der Grundplatte (13) befestigter erster Schenkel (27) und ein mit einem zweiten Ende (30) am Keilelement (19) befestigter zweiter Schenkel (28), verbunden sind, aufweist, wobei die Schenkel (27, 28) zwischen einer inaktiven Konfiguration, die bei inaktiver Position des Betätigungsglieds (16) eingenommen wird und in der sie eine erste Winkelöffnung definieren, und einer aktive Konfiguration, die bei aktiver Position des Betätigungsglieds (16) eingenommen wird und in der sie eine zweite Winkelöffnung, die höher liegt als die erste Winkelöffnung, definieren, verformt werden können, wobei ihre Enden (29, 30) näher an der inaktiven Konfiguration als an der aktiven Konfiguration liegen.

12. Keil (12) nach einem der Ansprüche 1 bis 10, bei dem das Betätigungsglied (16) eine an einem proximalen Ende der Grundplatte (13) angebrachte Schraube ist, die mit dem Keilelement (19) schraubenförmig in Eingriff steht.

13. System (1), das Folgendes umfasst:
- ein elektronisches Modul (3);
- eine Aufnahme (2) für das Modul (3);
- mindestens einen Keil (12) nach einem der Ansprüche 1 bis 12, der zwischen einer Seitenfläche (15) des elektronischen Moduls (3) und einer Seitenwand (10) der Aufnahme (2) eingeschoben ist.

14. System (1) nach Anspruch 13, das einen Handgriff (49) zur Befestigung des Moduls (3) an der Aufnahme (2) aufweist, wobei dieser Handgriff (49) an einer Vorderseite (48) des Moduls (3) zwischen einer Freigabeposition, in der er einen Winkel mit der Vorderseite (48) bildet, und einer Verriegelungsposition, in der er sich gegen die Vorderseite (48) erstreckt und dabei mit an der Aufnahme (2) vorgesehenen Verankerungsmitteln (51) und mit am Modul (3) vorgesehenen Verriegelungsmitteln (52) zusammenwirkt, angelenkt ist.

15. System (1) nach Anspruch 14, bei dem sich das Betätigungsglied (16) des Keils (12) in der inaktiven Position in der Bahn des Handgriffs (49) befindet, um sein Passieren aus der Freigabeposition in die Verriegelungsposition zu verhindern.

16. System (1) nach Anspruch 14 oder 15, bei dem die Verankerungsmittel (51) ein Verankerungsteil (53) umfassen, das ein U-förmiges Profil enthält, das zwei im Wesentlichen parallele, längliche Schenkel (54, 55) aufweist, die jeweils als Zugfeder konfiguriert sind, von der ein Ende (56) an einem an der Aufnahme (2) vorgesehenen Ansatz (57) festgehakt ist, wobei die Schenkel (54, 55) durch einen sich in Querrichtung erstreckenden Mittelteil (58) verbunden sind und wobei der Handgriff (49) zur Befestigung des Moduls (3) um eine in Querrichtung verlaufende Drehachse (59) angelenkt ist und einen sich bezüglich der Drehachse (59) freitragend erstreckenden Endteil (60) aufweist, wobei dieser Endteil (60) mit einem Haken (61) versehen ist, der mit dem Mittelteil (58) des Verankerungsteils (53) in Eingriff gelangen und dieses in Verriegelungsposition zugbelasten kann.
